# EUROPEAN PATENT APPLICATION

(11) **EP 4 664 768 A1**
(43) Date of publication of application: **17.12.2025**
(21) Application number: 24752822.7
(22) Date of filing: 04.02.2024
(51) Int. Cl.: H04B 1/04

(54) **LOW-LOSS RADIO FREQUENCY TRANSCEIVING FRONT-END MODULE AND ELECTRONIC DEVICE**

(30) Priority: 07.02.2023 CN 202310076137
(71) Applicant: Vanchip (Tianjin) Technology Co. Ltd, Tianjin 300457 (CN)
(72) Inventor: LI, Hao, Tianjin 300457 (CN); BAI, Yunfang, Tianjin 300457 (CN)
(74) Representative: Wang, Bo
(86) International application number: PCT/CN2024/075694
(87) International publication number: WO 2024/164967

(57) **Abstract**

Disclosed in the present invention are a low-loss radio frequency transceiving front-end module and an electronic device. The radio frequency transceiving front-end module comprises at least one PA transmitting path, at least one LNA receiving path, at least one bypass receiving path, and/or at least one bypass transmitting path; the at least one PA transmitting path or the at least one LNA receiving path is directly connected to an ANT port of an antenna, and the PA transmitting path or the LNA receiving path comprises at least one switch connected in parallel to the ground; the remaining PA transmitting path or LNA receiving path is connected to the ANT port of the antenna by means of a radio frequency switch. According to the radio frequency transceiving front-end module provided by the present invention, the noise coefficient of a receiving end and the output power and loss of a transmitting end are optimized by reducing the insertion loss of the radio frequency switch, without increasing the costs.

## Description

### BACKGROUND

### Technical Field

The present invention relates to a low-loss radio frequency transceiving front-end module, also, to an electronic device including the radio frequency transceiving front-end module, and belongs to the technical field of radio frequency integrated circuits.

### Related Art

With continuous development of wireless communications technologies, a communication terminal has an increasingly high requirement on a radio frequency transceiving front-end module. A noise figure (noise coefficient), transmit power, power consumption, and the like are main technical performance indicators of the radio frequency transceiving front-end module. A low noise figure can improve receiving sensitivity of the communication terminal, while high transmit power can increase signal coverage of the communication terminal.

Currently, requirements on the low noise figure and the high transmit power of the radio frequency transceiving front-end module are usually implemented by using an expensive semiconductor material or process, but this method obviously increases costs of the communication terminal. Therefore, how to optimize technical performance indicators, such as a noise coefficient, transmit power, and power consumption, of the radio frequency transceiving front-end module without increasing costs becomes an important technical topic.

### SUMMARY

A primary technical problem to be solved by the present invention is to provide a low-loss radio frequency transceiving front-end module.

Another technical problem to be solved by the present invention is to provide an electronic device including the aforementioned low-loss radio frequency transceiving front-end module.

To achieve the aforementioned objective, the technical solution used in the present invention is as follows:
According to a first aspect of an embodiment of the present invention, a low-loss radio frequency transceiving front-end module is provided, including at least one PA transmitting path, an LNA receiving path, a bypass receiving path, and/or a bypass transmitting path, where
the at least one PA transmitting path or the LNA receiving path is directly connected to an ANT port of an antenna, and the PA transmitting path or the LNA receiving path includes at least one switch connected in parallel to a ground; the remaining PA transmitting path or the LNA receiving path is connected to the ANT port of the antenna through a radio frequency switch; and
when the PA transmitting path or the LNA receiving path directly connected to the ANT port of the antenna is in an operating state, the switch connected in parallel to the ground on the PA transmitting path or the LNA receiving path is open, or when the PA transmitting path or the LNA receiving path directly connected to the ANT port of the antenna is in a non-operating state, the switch connected in parallel to the ground on the PA transmitting path or the LNA receiving path is closed.

A connection manner between the bypass receiving path and the ANT port of the antenna is the same as that between the bypass receiving path and the LNA receiving path corresponding to the bypass receiving path; and a connection manner between the bypass transmitting path and the ANT port of the antenna is the same as that between the bypass transmitting path and the PA transmitting path corresponding to the bypass transmitting path.

When the bypass transmitting path and/or the bypass transmitting path is in an operating state, each switch connected in parallel to the ground on the PA transmitting path and/or the LNA receiving path directly connected to the ANT port of the antenna is in a closed state.

Preferably, when the PA transmitting path or the LNA receiving path connected to the ANT port of the antenna through the radio frequency switch is in an operating state, the radio frequency switch connects a connection path between the PA transmitting path or the LNA receiving path and the ANT port of the antenna, or
when the PA transmitting path or the LNA receiving path connected to the ANT port of the antenna through the radio frequency switch is in a non-operating state, the radio frequency switch disconnects the connection path between the PA transmitting path or the LNA receiving path and the ANT port of the antenna.

Preferably, the PA transmitting path is composed of a power amplifier and a first output matching network connected in series, and the first output matching network is directly connected to the ANT port of the antenna or is connected to the ANT port of the antenna through the radio frequency switch, where the power amplifier is configured to implement power amplification of a transmitted signal, and the first output matching network is configured to implement impedance transformation; and
on the PA transmitting path directly connected to the ANT port of the antenna, the switch connected in parallel to the ground is connected in parallel behind the power amplifier, or the first output matching network is divided into two parts, and the switch connected in parallel to the ground is connected in parallel between the two parts.

Preferably, a 90° phase shift network is used as the first output matching network.

Preferably, the LNA receiving path is composed of a low noise amplifier and a first input matching network connected in series, and the first input matching network is directly connected to the ANT port of the antenna or is connected to the ANT port of the antenna through the radio frequency switch, where the low noise amplifier is configured to implement low noise amplification of a received signal, and the first input matching network is configured to implement impedance matching and noise matching; and
on the LNA receiving path directly connected to the ANT port of the antenna, the switch connected in parallel to the ground is connected in parallel before the low noise amplifier, or the first input matching network is divided into two parts, and the switch connected in parallel to the ground is connected in parallel between the two parts.

Preferably, a 90° phase shift network is used as the first input matching network.

Preferably, the bypass transmitting path is composed of a series switch and a second output matching network connected in series, where the series switch is configured to connect or disconnect the bypass transmitting path, and the second output matching network is configured to implement impedance transformation; and
the series switch is closed when the bypass transmitting path is in an operating state, or the series switch is open when the bypass transmitting path is in a non-operating state.

Preferably, the bypass receiving path is composed of a series switch and a second input matching network connected in series, where the series switch is configured to connect or disconnect the bypass receiving path, and the second input matching network is configured to implement impedance matching and gain reduction; and
the series switch is closed when the bypass receiving path is in an operating state, or the series switch is open when the bypass receiving path is in a non-operating state.

According to a second aspect of an embodiment of the present invention, an electronic device is provided, including the aforementioned low-loss radio frequency transceiving front-end module.

Compared with the prior art, the low-loss radio frequency transceiving front-end module according to the present invention optimizes a noise figure of a receiving end and output power and a loss of a transmitting end by reducing an insertion loss of the radio frequency switch without increasing costs. Therefore, the technical solution provided in the present invention has the beneficial effects of ingenious and appropriate design, simple structure, low production costs, excellent performance of the radio frequency transceiving front-end module, and the like.

### BRIEF DESCRIPTION OF THE DRAWINGS

FIG. 1 is a schematic diagram of a typical radio frequency transceiving front-end module in the prior art;
FIG. 2 is a schematic diagram of a second typical radio frequency transceiving front-end module in the prior art;
FIG. 3 is a schematic diagram of a third typical radio frequency transceiving front-end module in the prior art;
FIG. 4 is a schematic diagram of a fourth typical radio frequency transceiving front-end module in the prior art;
FIG. 5 is a schematic diagram of a radio frequency transceiving front-end module according to Embodiment 1 of the present invention;
FIG. 6 is a diagram of a circuit principle of the radio frequency transceiving front-end module according to Embodiment 1 of the present invention;
FIG. 7 is a schematic diagram of a radio frequency transceiving front-end module according to Embodiment 2 of the present invention;
FIG. 8 is a diagram of a circuit principle of a radio frequency transceiving front-end module according to Embodiment 2 of the present invention;
FIG. 9 is a schematic diagram of a radio frequency transceiving front-end module according to Embodiment 3 of the present invention;
FIG. 10 is a diagram of a circuit principle of the radio frequency transceiving front-end module according to Embodiment 3 of the present invention;
FIG. 11 is a schematic diagram of a radio frequency transceiving front-end module according to Embodiment 4 of the present invention;
FIG. 12 is a comparison diagram of noise figure simulation test effects in technical solutions provided in the prior art and an embodiment of the present invention;
FIG. 13 is a comparison diagram of saturation power simulation test effects in technical solutions provided in the prior art and an embodiment of the present invention; and
FIG. 14 is an example diagram of an electronic device with a radio frequency transceiving front-end module according to the present invention.

### DETAILED DESCRIPTION

The technical solutions of the present invention are further described in detail below with reference to the accompanying drawings and specific embodiments.

To facilitate understanding and explanation, in the present invention, several typical radio frequency transceiving front-end modules and antenna terminals thereof in the prior art are first briefly described, and based on this, an improved technical solution of an embodiment of the present invention is described.

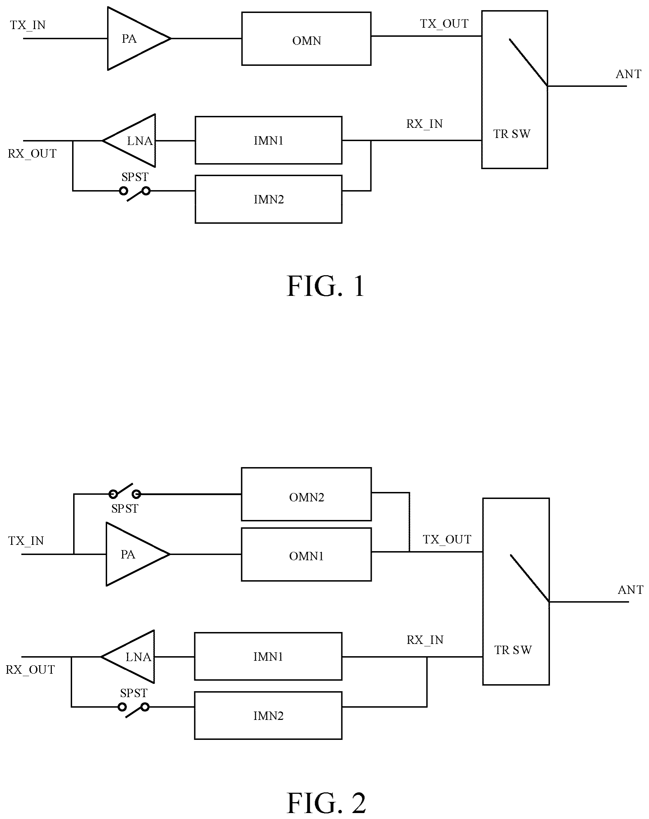

FIG. 1 shows a radio frequency transceiving front-end module in the prior art, which includes a power amplifier (PA) transmitting path, a low noise amplifier (LNA) receiving path, a bypass receiving path, and a radio frequency switch TR_SW. An input end of the PA transmitting path is TX_IN, and an output end of the PA transmitting path is TX_OUT. An input end of the receiving path is RF_IN, and an output end of the receiving path is RF_OUT. The PA transmitting path is connected to an ANT port of an antenna through the radio frequency switch TR_SW; the bypass receiving path connects the LNA receiving path to the ANT port of the antenna through the radio frequency switch TR_SW.

The PA transmitting path is composed of a power amplifier and an output matching network (OMN) connected in series. The power amplifier is configured to implement power amplification of a transmitted signal, and the output matching network is configured to implement impedance transformation and is generally composed of a passive network including a capacitor, an inductor, a switch, and the like. The LNA receiving path is composed of a low noise amplifier and an input matching network (IMN) 1 connected in series. The low noise amplifier is configured to implement low noise amplification of a received signal, and the first input matching network 1 is configured to implement impedance matching and noise matching, and is generally composed of a passive network including a capacitor, an inductor, a switch, and the like. The bypass receiving path is composed of a switch SPST and a second input matching network 2 connected in series. The switch SPST is configured to connect or disconnect the bypass receiving path, and the second input matching network 2 is configured to implement impedance matching and gain reduction, and is generally composed of a passive network including a capacitor, an inductor, a switch, and the like. The radio frequency switch TR_SW is configured to switch between radio frequency paths with transmitting and receiving functions, and isolate the output end TX_OUT of the transmitting path from the input end RF_IN of the receiving path, to prevent the transmitting path and the receiving path from affecting each other.

FIG. 2 shows a second radio frequency transceiving front-end module in the prior art, which includes a PA transmitting path and a bypass transmitting path, an LNA receiving path and a bypass receiving path, and a radio frequency transceiving switch TR_SW. The PA transmitting path and the bypass transmitting path, and the LNA receiving path and the bypass receiving path each are connected to the ANT port of the antenna through the radio frequency transceiving switch TR_SW. Compared with that of the radio frequency transceiving front-end module shown in FIG. 1, one bypass transmitting path is added in this embodiment.

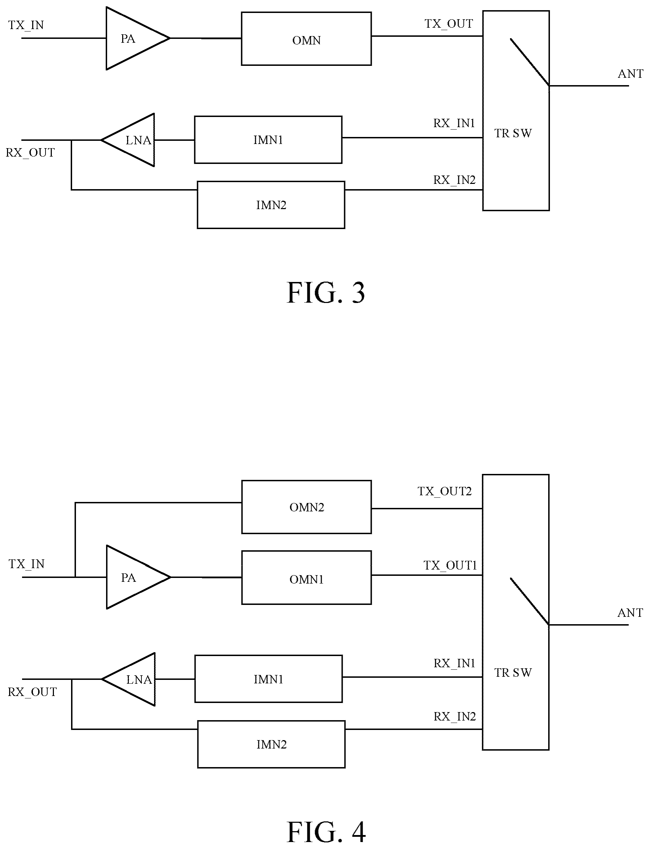

FIG. 3 shows a third radio frequency transceiving front-end module in the prior art, which includes a PA transmitting path, an LNA receiving path, a bypass receiving path, and a radio frequency transceiving switch TR_SW. This embodiment is a variation of the embodiment shown in FIG. 1. Compared with that of the radio frequency transceiving front-end module shown in FIG. 1, in this embodiment, the switch SPST on the bypass receiving path is integrated into a radio frequency transceiving switch TR_SW circuit.

FIG. 4 shows a fourth radio frequency transceiving front-end module in the prior art, which includes a PA transmitting path and a bypass transmitting path, an LNA receiving path and a bypass receiving path, and a radio frequency transceiving switch TR_SW. This embodiment is a different implementation form of the solution shown in FIG. 2. Compared with that of the radio frequency transceiving front-end module shown in FIG. 2, in this embodiment, a switch SPST on the bypass transmitting path and a switch SPST on the bypass receiving path are both integrated into a radio frequency transceiving switch TR_SW circuit.

In the aforementioned radio frequency transceiving front-end module, a power amplifier on the transmitting path and a low noise amplifier on the receiving path each may have a plurality of gain modes. In addition, a total noise figure (NF) of the ANT port of the antenna includes an insertion loss of the radio frequency switch TR_SW, an insertion loss of an input matching network, and a noise figure (NF) of the low noise amplifier. Total transmit power of the ANT port of the antenna is output power of the power amplifier minus an insertion Loss of an output matching network and the insertion loss of the radio frequency switch TR_SW.

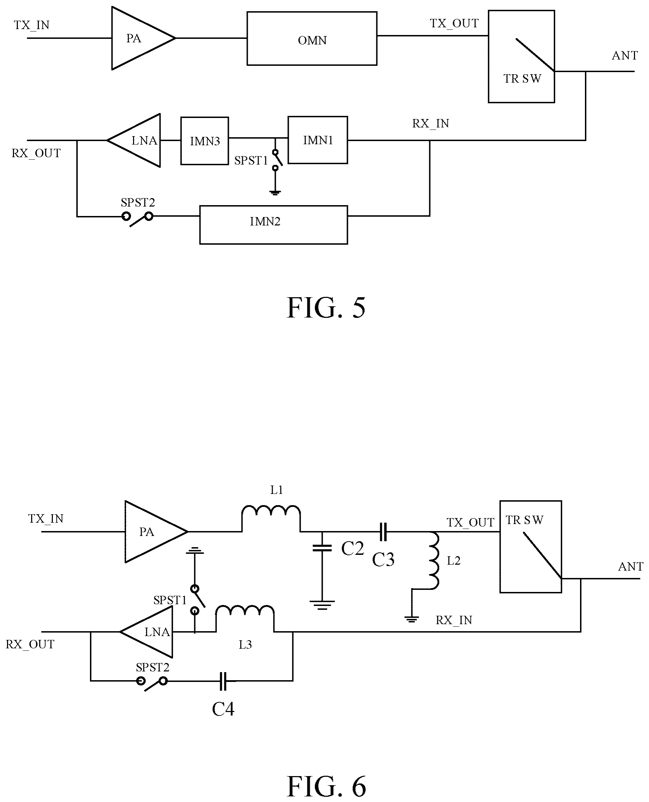

As shown in FIG. 5 to FIG. 11, an embodiment of the present invention first provides a low-loss radio frequency transceiving front-end module, a low-loss radio frequency transceiving front-end module, including at least one PA transmitting path, an LNA receiving path, a bypass receiving path, and/or a bypass transmitting path. The at least one PA transmitting path or the LNA receiving path is directly connected to an ANT port of an antenna, and the PA transmitting path or the LNA receiving path includes at least one switch connected in parallel to a ground; and the remaining PA transmitting path or the LNA receiving path is connected to the ANT port of the antenna through a radio frequency switch (TR_SW).

When the PA transmitting path or the LNA receiving path directly connected to the ANT port of the antenna is in an operating state, the switch connected in parallel to the ground on the PA transmitting path or the LNA receiving path is open, or when the PA transmitting path or the LNA receiving path directly connected to the ANT port of the antenna is in a non-operating state, the switch connected in parallel to the ground on the PA transmitting path or the LNA receiving path is closed.

A connection manner between the bypass receiving path and the ANT port of the antenna is the same as that between the bypass receiving path and the LNA receiving path corresponding to the bypass receiving path; and a connection manner between the bypass transmitting path and the ANT port of the antenna is the same as that between the bypass transmitting path and the PA transmitting path corresponding to the bypass transmitting path.

FIG. 5 shows a low-loss radio frequency transceiving front-end module according to Embodiment 1 of the present invention, which includes a PA transmitting path, an LNA receiving path, a bypass receiving path, and a radio frequency switch TR_SW. The PA transmitting path is connected to an ANT port of an antenna through the radio frequency switch TR_SW, and the LNA receiving path and the bypass receiving path are directly connected to the ANT port of the antenna.

The PA transmitting path is composed of a power amplifier and an output matching network connected in series. The power amplifier is configured to implement power amplification of a transmitted signal. The output matching network is configured to implement impedance transformation and is generally composed of a passive network including a capacitor, an inductor, a switch, and the like.

The LNA receiving path is composed of a low noise amplifier, a first input matching network 1, a third input matching network 3, and a switch SPST1. The low noise amplifier, the first input matching network 1 and the third input matching network 3 are sequentially connected in series. One end of the switch SPST1 is connected between the first input matching network 1 and the third input matching network 3, and the other end thereof is connected to a ground potential terminal, and is a switch connected in parallel to the ground. The low noise amplifier is configured to implement low noise amplification of a received signal, and the first input matching network 1 and the third input matching network 3 each are configured to implement impedance matching and noise matching, and are generally composed of a passive network including a capacitor, an inductor, a switch, and the like.

The bypass receiving path is composed of a switch SPST2 and a second input matching network 2 connected in series. The switch SPST2 is configured to connect or disconnect the bypass receiving path. The second input matching network 2 is configured to implement impedance matching and gain reduction, and is generally composed of a passive network including a capacitor, an inductor, a switch, and the like.

The radio frequency switch TR_SW is a single pole single throw switch, and is only configured to connect or disconnect the transmitting path, and isolate the output end TX_OUT of the transmitting path from the input end RF_IN of the receiving path, to prevent the transmitting path and the receiving path from affecting each other.

With reference to FIG. 5, an operating principle of the low-loss radio frequency transceiving front-end module according to Embodiment 1 of the present invention is described in detail below.

When the LNA receiving path operates, the radio frequency switch TR_SW is in a high impedance state after being opened, to isolate the receiving path from the transmitting path. The switch SPST2 is in a high impedance state after being opened, so that the bypass receiving path is in a disconnected state. The switch SPST1 connected in parallel to the ground is in a high impedance state after being opened, so that the LNA receiving path operates normally.

When the PA transmitting path operates, the radio frequency switch TR_SW is in an on state after being closed, so that the PA transmitting path operates normally. The switch SPST1 connected in parallel to the ground is in a grounded state after being closed, to isolate the receiving path from the transmitting path, so that the input end of the LNA receiving path is not affected by the transmit power, and damage and harmonics generated by a device at the receiving end are avoided. In this case, the output matching network and the first input matching network 1 of the LNA receiving path jointly implement impedance matching of the transmitting path. The switch SPST2 is in a high impedance state after being opened, so that the bypass receiving path is in a disconnected state.

When the bypass receiving path operates, the radio frequency switch TR_SW is in a high impedance state after being opened, to isolate the receiving path from the transmitting path. The switch SPST2 is in an on state after being closed, so that the bypass receiving path operates normally. The switch SPST1 connected in parallel to the ground is in a grounded state after being closed. In this case, the second input matching network 2 and the first input matching network 1 of the LNA receiving path jointly implement impedance matching of the transmitting path.

Based on a commonly used form of a passive network, which includes a capacitor, an inductor, a switch, and the like, of the input matching network and the output matching network, a diagram of a circuit principle of the low-loss radio frequency transceiving front-end module according to Embodiment 1 of the present invention is shown in FIG. 6. The output matching network of the PA transmitting path is composed of a series inductor L1, a parallel capacitor C2, a series capacitor C3, and a parallel inductor L2 that are sequentially connected. The first input matching network 1 of the LNA receiving path is composed of a series inductor L3. The second input matching network 2 of the bypass receiving path is composed of a series capacitor C4.

Compared with that of the prior art shown in FIG. 1, in the low-loss radio frequency transceiving front-end module according to Embodiment 1 of the present invention, since the LNA receiving path and the bypass receiving path are directly connected to the ANT port of the antenna, an insertion loss caused by the radio frequency switch TR_SW is removed from the receiving path, so that total noise figure (NF) of the ANT port of the antenna is optimized.

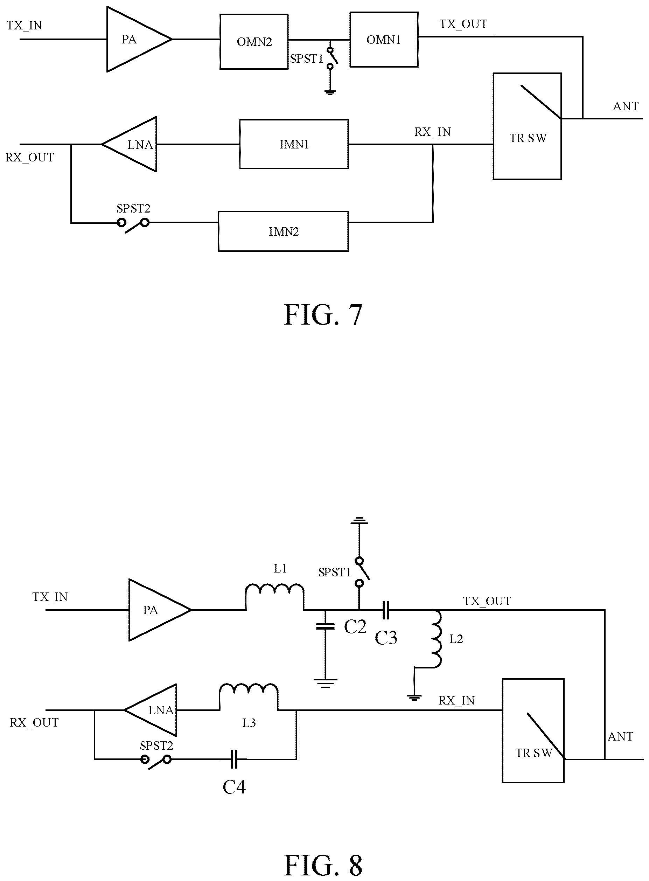

FIG. 7 shows a low-loss radio frequency transceiving front-end module according to Embodiment 2 of the present invention, which includes a PA transmitting path, an LNA receiving path, a bypass receiving path, and a radio frequency switch TR_SW. The PA transmitting path is directly connected to an ANT port of an antenna, and the LNA receiving path and the bypass receiving path each are connected to the ANT port of the antenna through the radio frequency switch TR_SW.

The PA transmitting path is composed of a power amplifier, a first output matching network 1, a second output matching network 2, and a switch SPST1. The power amplifier, the first output matching network 1 and the second output matching network 2 are sequentially connected in series. One end of the switch SPST1 is connected between the first output matching network 1 and the second output matching network 2, and the other end thereof is connected to a ground potential terminal, and is a switch connected in parallel to the ground. The LNA receiving path is composed of a low noise amplifier and a first input matching network 1 connected in series. The bypass receiving path is composed of a switch SPST2 and a second input matching network 2 connected in series. The radio frequency switch TR_SW is a single pole single throw switch, and is only configured to connect or disconnect the receiving path, and isolate the output end TX_OUT of the transmitting path from the input end RF_IN of the receiving path, to prevent the transmitting path and the receiving path from affecting each other.

With reference to FIG. 7, an operating principle of the low-loss radio frequency transceiving front-end module according to Embodiment 2 of the present invention is described in detail below.

When the PA transmitting path operates, the radio frequency switch TR_SW is in a high impedance state after being opened, to isolate the receiving path from the transmitting path. The switch SPST1 connected in parallel to the ground is in a high impedance state after being opened, so that the PA transmitting path operates normally. The switch SPST2 is in a high impedance state after being opened, so that the bypass receiving path is in a disconnected state.

When the LNA receiving path operates, the radio frequency switch TR_SW is in an on state after being closed, so that the LNA receiving path operates normally. The switch SPST1 connected in parallel to the ground is in a grounded state after being closed, to isolate the receiving path from the transmitting path. In this case, the first input matching network 1 and the first output matching network 1 of the PA transmitting path jointly implement impedance matching of the receiving path. The switch SPST2 is in a high impedance state after being opened, so that the bypass receiving path is in a disconnected state.

When the bypass receiving path operates, the radio frequency switch TR_SW is in an on state after being closed, so that the bypass receiving path operates normally. The switch SPST2 is in an on state after being closed, so that the bypass receiving path operates normally. The switch SPST1 connected in parallel to the ground is in a grounded state after being closed. In this case, the second input matching network 2 and the first output matching network 1 of the PA transmitting path jointly implement impedance matching of the transmitting path.

Based on a commonly used form of a passive network, which includes a capacitor, an inductor, a switch, and the like, of the input matching network and the output matching network, a diagram of a circuit principle of the low-loss radio frequency transceiving front-end module according to Embodiment 2 of the present invention is shown in FIG. 8. The second output matching network 2 of the PA transmitting path is composed of a series inductor L1 and a parallel capacitor C2 that are sequentially connected. The first output matching network 1 of the PA transmitting path is composed of a series capacitor C3 and a parallel inductor L2 that are sequentially connected. The first input matching network 1 of the LNA receiving path is composed of a series inductor L3. The second input matching network 2 of the bypass receiving path is composed of a series capacitor C4.

Compared with that of the prior art shown in FIG. 1, in the low-loss radio frequency transceiving front-end module according to Embodiment 2 of the present invention, since the PA transmitting path is directly connected to the ANT port of the antenna, an insertion loss caused by the radio frequency switch TR_SW is removed from the transmitting path, so that total transmit power and efficiency of the ANT port of the antenna are improved.

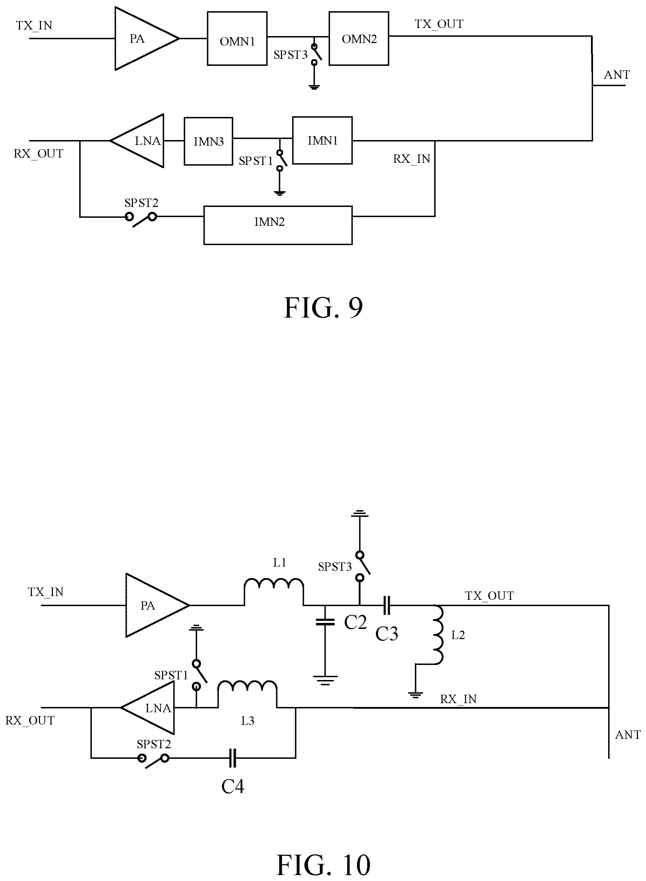

FIG. 9 shows a low-loss radio frequency transceiving front-end module according to Embodiment 3 of the present invention, which includes a PA transmitting path, an LNA receiving path, and a bypass receiving path. The PA transmitting path, the LNA receiving path and the bypass receiving path are all directly connected to the ANT port of the antenna.

The PA transmitting path is composed of a power amplifier, a first output matching network 1, a second output matching network 2, and a switch SPST3. The power amplifier, the first output matching network 1 and the second output matching network 2 are sequentially connected in series. One end of the switch SPST3 is connected between the first output matching network 1 and the second output matching network 2, and the other end thereof is connected to a ground potential terminal, and is a switch connected in parallel to the ground.

The LNA receiving path is composed of a low noise amplifier, a first input matching network 1, a third input matching network 3, and a switch SPST1. The low noise amplifier, the first input matching network 1, and the third input matching network 3 are sequentially connected in series. One end of the switch SPST1 is connected between the first input matching network 1 and the third input matching network 3, and the other end thereof is connected to a ground potential terminal, and is a switch connected in parallel to the ground.

The bypass receiving path is composed of a switch SPST2 and a second input matching network 2 connected in series.

With reference to FIG. 9, an operating principle of the low-loss radio frequency transceiving front-end module according to Embodiment 3 of the present invention is described in detail below.

When the PA transmitting path operates, the switch SPST3 connected in parallel to the ground is in a high impedance state after being opened, so that the PA transmitting path operates normally. The switch SPST2 is in a high impedance state after being opened, so that the bypass receiving path is in a disconnected state. The switch SPST1 connected in parallel to the ground is in a grounded state after being closed, to isolate the receiving path from the transmitting path in this case, so that the input end of the LNA receiving path is not affected by the transmit power, and damage and harmonics generated by a device at the receiving end are avoided. In this case, the first output matching network 1, the second output matching network 2 and the first input matching network 1 of the LNA receiving path jointly implement impedance matching of the transmitting path.

When the LNA receiving path operates, the switch SPST1 connected in parallel to the ground is in a high impedance state after being opened, so that the LNA receiving path operates normally. The switch SPST2 is in a high impedance state after being opened, so that the bypass receiving path is in a disconnected state. The switch SPST3 connected in parallel to the ground is in a grounded state after being closed, to isolate the receiving path from the transmitting path. In this case, the first input matching network 1, the third input matching network 3 and the second output matching network 2 of the PA transmitting path jointly implement impedance matching of the receiving path.

When the bypass receiving path operates, the switch SPST2 is in an on state after being closed, so that the bypass receiving path operates normally. The switch SPST3 connected in parallel to the ground is in a grounded state after being closed, and the switch SPST1 connected in parallel to the ground is in a grounded state after being closed. In this case, the second input matching network 2, the first input matching network 1 of the LNA receiving path and the second output matching network 2 of the PA transmitting path jointly implement impedance matching of the bypass receiving path.

Based on a commonly used form of a passive network, which includes a capacitor, an inductor, a switch, and the like, of the input matching network and the output matching network, a diagram of a circuit principle of the low-loss radio frequency transceiving front-end module according to Embodiment 3 of the present invention is shown in FIG. 10. The first output matching network 1 of the PA transmitting path is composed of a series inductor L1 and a parallel capacitor C2 that are sequentially connected. The second output matching network 2 of the PA transmitting path is composed of a series capacitor C3 and a parallel inductor L2 that are sequentially connected. The first input matching network 1 of the LNA receiving path is composed of a series inductor L3. The second input matching network 2 of the bypass receiving path is composed of a series capacitor C4.

In addition, in the low-loss radio frequency transceiving front-end module according to Embodiment 3 of the present invention, a 90° phase shift network may be used as each of the second output matching network 2 of the PA transmitting path and the first input matching network 1 of the LNA receiving path, so that impedance matching of the receiving path and the transmitting path does not affect each other. In addition, an effect of signal isolation between the receiving path and the transmitting path is improved. A specific operating process is as follows.

When the PA transmitting path operates, the switch SPST3 connected in parallel to the ground is in a high impedance state after being opened, the switch SPST2 is in a high impedance state after being opened, and the switch SPST1 connected in parallel to the ground is in a grounded state after being closed, to isolate the receiving path from the transmitting path. In this case, impedance of an input end RF_IN of the receiving path seen from an output end TX_OUT of the transmitting path is in a high impedance state presented by the first input matching network 1. Therefore, the input end RF_IN of the receiving path does not affect impedance matching of the output end TX_OUT of the transmitting path, and improves an effect of signal isolation between the receiving path and the transmitting path.

When the LNA receiving path operates, the switch SPST3 connected in parallel to the ground is in a grounded state after being closed, to isolate the receiving path from the transmitting path. The switch SPST2 is in a high impedance state after being opened, and the switch SPST1 connected in parallel to the ground is in a high impedance state after being opened. In this case, impedance of the output end TX_OUT of the transmitting path seen from the input end RF_IN of the receiving path is in a high impedance state presented by the second output matching network 2. Therefore, the output end TX_OUT of the transmitting path does not affect impedance matching of the input end RF_IN of the receiving path, and improves an effect of signal isolation between the receiving path and the transmitting path.

When the bypass receiving path operates, the switch SPST2 is an on state after being closed, the switch SPST3 connected in parallel to the ground is in a grounded state after being closed, and the switch SPST1 connected in parallel to the ground is in a grounded state after being closed. In this case, the second output matching network 2 and the first input matching network 1 are both in a high impedance state. Therefore, impedance matching of the second input matching network 2 of the bypass receiving path is not affected.

Compared with that of the prior art shown in FIG. 1, in the low-loss radio frequency transceiving front-end module according to Embodiment 3 of the present invention, since the PA transmitting path, the LNA receiving path and the bypass receiving path are all directly connected to the ANT port of the antenna, an insertion loss caused by the radio frequency switch TR_SW is removed from the transmitting path, so that total transmit power and efficiency of the ANT port of the antenna are improved. An insertion loss caused by the radio frequency switch TR_SW is removed from the receiving path, so that a total noise figure (NF) of the ANT port of the antenna is optimized.

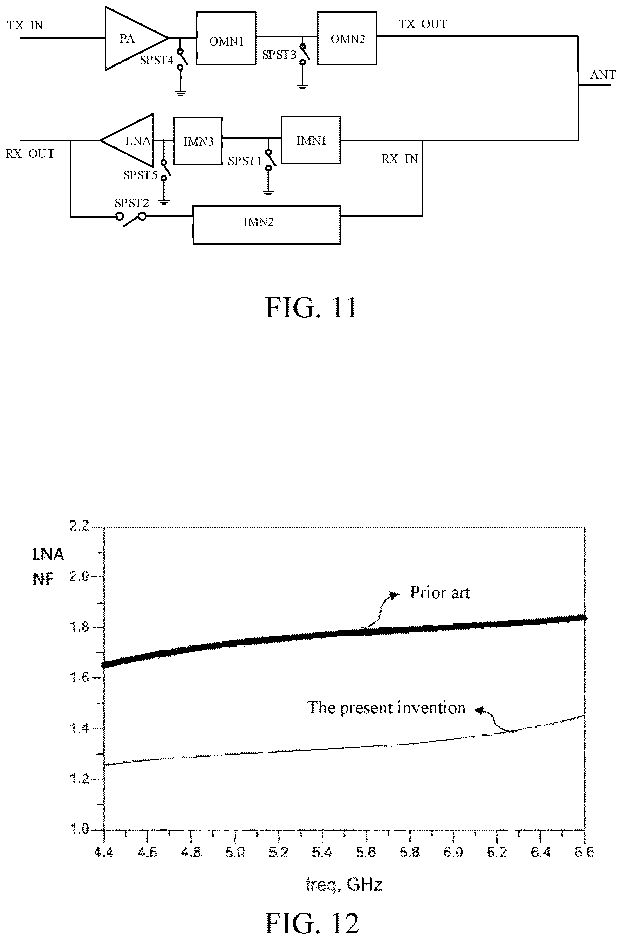

FIG. 11 shows a low-loss radio frequency transceiving front-end module according to Embodiment 4 of the present invention, which includes a PA transmitting path, an LNA receiving path, and a bypass receiving path. The PA transmitting path, the LNA receiving path and the bypass receiving path are all directly connected to the ANT port of the antenna.

Compared with that of the low-loss radio frequency transceiving front-end module (see FIG. 9) according to Embodiment 3 of the present invention, in Embodiment 4, a switch SPST4 connected in parallel to the ground is added to the PA transmitting path, and the switch connected in parallel to the ground is connected in parallel behind the power amplifier (PA). A switch SPST5 connected in parallel to the ground is added to the LNA receiving path. The switch SPST5 connected in parallel to the ground is connected in parallel before the low noise amplifier to increase isolation between the transmitting path and the receiving path. An operating state of the switch SPST4 connected in parallel to the ground is the same as that of the switch SPST3 connected in parallel to the ground on the PA transmitting path, and an operating state of the switch SPST5 connected in parallel to the ground is the same as that of the switch SPST1 connected in parallel to the ground on the LNA receiving path. Other circuit structures and operating principles are the same as those of Embodiment 3, and details are not described herein.

It should be noted that, the technical solutions of the above four embodiments are all based on the prior art shown in FIG. 1, and are proposed by using the technical solution of reducing the insertion loss of the radio frequency switch to optimize the noise figure of the receiving end and the output power and the loss of the transmitting end. Similarly, based on the prior art shown in FIG. 2, FIG. 3, and FIG. 4, in the present invention, improved technical solutions corresponding to the above four embodiments can also be implemented, and the structure and the operating principle of the radio frequency transceiving front-end module are the same as or similar to those of the above four embodiments. In another aspect, the technical solutions of the above four embodiments are all analyzed and explained by taking a radio frequency transceiving front-end module including a PA transmitting path, an LNA receiving path, and a bypass path as an example. A circuit structure and an operating principle of a radio frequency transceiving front-end module including a plurality of PA transmitting paths, a plurality of LNA receiving paths and a plurality of bypass paths are the same as or similar to those of the above four embodiments. Details are not described herein.

The technical solutions provided in the present invention are described in detail above through a plurality of embodiments. To verify excellent performance of the radio frequency transceiving front-end module according to the present invention, the inventors performed simulation tests on the noise figure and saturation power of the technical solutions provided in the prior art and the embodiments of the present invention. Test results are as follows.

FIG 12 is a diagram of noise figure simulation test effects of a radio frequency transceiving front-end module. A horizontal coordinate denotes a frequency, and a vertical coordinate denotes a noise figure of an LNA receiving path. As can be seen from FIG. 12, in a frequency range of 4.4 GHz to 6.6 GHz, compared with that of the prior art, the noise figure value in the technical solution provided in the embodiment of the present invention was less than the noise figure of the prior art.

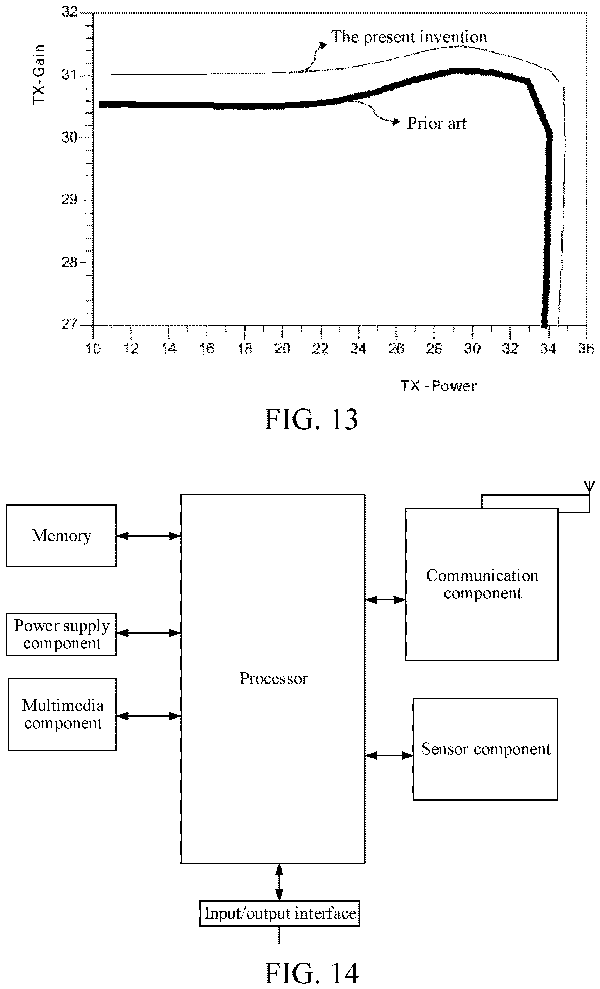

FIG 13 is a diagram of saturation power simulation test effects of a radio frequency transceiving front-end module. A horizontal coordinate denotes output power of a PA transmitting path, and a vertical coordinate denotes a gain of the PA transmitting path. As can be seen from FIG. 13, compared with that of the prior art, a saturation power value in the technical solution provided in the embodiment of the present invention was greater than a saturation power value of the prior art by about 0.5.

The low-loss radio frequency transceiving front-end module according to the present invention can be used in an electronic device as an important part of a radio frequency integrated circuit. The electronic device mentioned herein refers to a computer device that can be used in a mobile environment and support a plurality of communication standards, such as GSM, EDGE, TD_SCDMA, TDD_LTE, FDD_LTE, and 5G, and includes a mobile phone, a notebook computer, a tablet computer, an in-vehicle computer, or the like. In addition, the technical solution provided in the present invention is also suitable for other occasions in which a radio frequency integrated circuit is applied, such as a communication base station and an intelligent connected vehicle.

As shown in FIG. 14, the electronic device includes at least a processor and a memory, and may further include a communication component, a sensor component, a power supply component, a multimedia component, and an input/output interface according to actual needs. The memory, the communication component, the sensor component, the power supply component, the multimedia component and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field programmable gate array (FPGA), an application-specific integrated circuit (ASIC), a digital signal processing (DSP) chip, or the like. Other communication components, sensor components, power supply components, multimedia components, and the like may be implemented by universal components. This is not specifically described herein.

From the specific description of the technical solution of the present invention in the above embodiments, it can be seen that compared with the prior art, the low-loss radio frequency transceiving front-end module according to the present invention optimizes the noise figure of the receiving end and output power and the loss of the transmitting end by reducing the insertion loss of the radio frequency switch without increasing costs. Therefore, the improved technical solution provided in the present invention has the beneficial effects of ingenious and appropriate design, simple structure, low production costs, excellent performance of the radio frequency transceiving front-end module, and the like.

The low-loss radio frequency transceiving front-end module and the electronic device according to the present invention are described in detail above. For a person of ordinary skill in the art, any obvious changes made to the present invention without departing from essential content thereof fall within the protection scope of the patent right of the present invention.

## Claims

1. A low-loss radio frequency transceiving front-end module, comprising at least one PA transmitting path, at least one LNA receiving path, at least one bypass receiving path, and/or at least one bypass transmitting path, wherein
the PA transmitting paths or the LNA receiving path is directly connected to an ANT port of an antenna, and the PA transmitting path or the LNA receiving path comprises at least one switch connected in parallel to a ground; the PA transmitting path or the LNA receiving path is connected to the ANT port of the antenna through a radio frequency switch; and
when the PA transmitting path or the LNA receiving path directly connected to the ANT port of the antenna is in an operating state, the switch connected in parallel to the ground on the PA transmitting path or the LNA receiving path is open, or when the PA transmitting path or the LNA receiving path directly connected to the ANT port of the antenna is in a non-operating state, the switch connected in parallel to the ground on the PA transmitting path or the LNA receiving path is closed.

2. The low-loss radio frequency transceiving front-end module according to claim 1, wherein
a connection manner between the bypass receiving path and the ANT port of the antenna is the same as that between the bypass receiving path and the LNA receiving path; and a connection manner between the bypass transmitting path and the ANT port of the antenna is the same as that between the bypass transmitting path and the PA transmitting path corresponding to the bypass transmitting path.

3. The low-loss radio frequency transceiving front-end module according to claim 1, wherein
when the PA transmitting path or the LNA receiving path connected to the ANT port of the antenna through the radio frequency switch is in an operating state, the radio frequency switch connects a connection path between the PA transmitting path or the LNA receiving path and the ANT port of the antenna, or
when the PA transmitting path or the LNA receiving path connected to the ANT port of the antenna through the radio frequency switch is in a non-operating state, the radio frequency switch disconnects the connection path between the PA transmitting path or the LNA receiving path and the ANT port of the antenna.

4. The low-loss radio frequency transceiving front-end module according to claim 1, wherein
the PA transmitting path is composed of a power amplifier and a first output matching network connected in series, and the first output matching network is directly connected to the ANT port of the antenna or is connected to the ANT port of the antenna through the radio frequency switch, wherein the power amplifier is configured to implement power amplification of a transmitted signal, and the first output matching network is configured to implement impedance transformation; and
on the PA transmitting path directly connected to the ANT port of the antenna, the switch connected in parallel to the ground is connected in parallel behind the power amplifier, or the first output matching network is divided into two parts, and the switch connected in parallel to the ground is connected in parallel between the two parts.

5. The low-loss radio frequency transceiving front-end module according to claim 4, wherein
a 90° phase shift network is used as the first output matching network.

6. The low-loss radio frequency transceiving front-end module according to claim 1, wherein
the LNA receiving path is composed of a low noise amplifier and a first input matching network connected in series, and the first input matching network is directly connected to the ANT port of the antenna or is connected to the ANT port of the antenna through the radio frequency switch, wherein the low noise amplifier is configured to implement low noise amplification of a received signal, and the first input matching network is configured to implement impedance matching and noise matching; and
on the LNA receiving path directly connected to the ANT port of the antenna, the switch connected in parallel to the ground is connected in parallel before the low noise amplifier, or the first input matching network is divided into two parts, and the switch connected in parallel to the ground is connected in parallel between the two parts.

7. The low-loss radio frequency transceiving front-end module according to claim 6, wherein
a 90° phase shift network is used as the first input matching network.

8. The low-loss radio frequency transceiving front-end module according to claim 1, wherein
the bypass transmitting path is composed of a series switch and a second output matching network connected in series, wherein the series switch is configured to connect or disconnect the bypass transmitting path, and the second output matching network is configured to implement impedance transformation; and
the series switch is closed when the bypass transmitting path is in an operating state, or the series switch is open when the bypass transmitting path is in a non-operating state.

9. The low-loss radio frequency transceiving front-end module according to claim 1, wherein
the bypass receiving path is composed of a series switch and a second input matching network connected in series, wherein the series switch is configured to connect or disconnect the bypass receiving path, and the second input matching network is configured to implement impedance matching and gain reduction; and
the series switch is closed when the bypass receiving path is in an operating state, or the series switch is open when the bypass receiving path is in a non-operating state.

10. The low-loss radio frequency transceiving front-end module according to claim 1, wherein
when the bypass transmitting path and/or the bypass transmitting path is in an operating state, each switch connected in parallel to the ground on the PA transmitting path and/or the LNA receiving path directly connected to the ANT port of the antenna is in a closed state.

11. An electronic device, comprising the low-loss radio frequency transceiving front-end module according to any one of claims 1 to 10.
